Europäisches Patentamt

European Patent Office

Office européen des brevets

(11) Publication number: **0 565 085 A2**

# EUROPEAN PATENT APPLICATION

(21) Application number: **93105773.1**

(22) Date of filing: **07.04.93**

(51) Int. Cl.5: **G01R 33/032**

(30) Priority: **10.04.92 JP 90976/92**

(43) Date of publication of application:
**13.10.93 Bulletin 93/41**

(84) Designated Contracting States:
**DE FR GB**

(71) Applicant: **MITSUBISHI GAS CHEMICAL COMPANY, INC.**
**5-2, Marunouchi 2-chome**
**Chiyoda-Ku**
**Tokyo, 100(JP)**

(72) Inventor: **Shirai, Kazushi, c/o Mitsubishi Gas Chem. Co. Inc.**
**Tokyo Laboratory 1-1,**
**Niijuku 6-chome**
**Katsushika-ku, Tokyo 125(JP)**
Inventor: **Shinbo, Toshihiro, c/o Mitsubishi Gas Chem.Co.Inc.**
**Tokyo Laboratory 1-1,**
**Niijuku 6-chome**
**Katsushika-ku, Tokyo 125(JP)**
Inventor: **Takeda, Norio, c/o Mitsubishi Gas Chem. Co. Inc.**
**Tokyo Laboratory 1-1,**
**Niijuku 6-chome**
**Katsushika-ku, Tokyo 125(JP)**
Inventor: **Arii, Mitsuzo, c/o Mitsubishi Gas Chem. Co. Inc.**
**Tokyo Laboratory 1-1,**
**Niijuku 6-chome**
**Katsushika-ku, Tokyo 125(JP)**

(74) Representative: **KUHNEN, WACKER & PARTNER**
**Alois-Steinecker-Strasse 22**
**D-85354 Freising (DE)**

(54) **Magnetic field sensor.**

(57) A reflection type magnetooptic sensor head includes a reflection film, a (111) bismuth-substituted iron garnet single crystal film, a polarizer, and a light-inputting/outputting device having an incoming-light path and an outgoing-light path. These structural elements are aligned in this order beginning from a tip end of the magnetooptic sensor head. The two light paths are aligned such that they make an angle substantially greater than five degrees with each other. The reflection type magnetooptic sensor head is used for a magnetooptic measuring apparatus.

# F I G. 7 A

# F I G. 7 B

## BACKGROUND OF THE INVENTION

Field of the Invention

The present invention relates to a magnetooptic sensor based on Faraday effect of a bismuth-substituted iron garnet, and more particularly to the construction of a magnetooptic sensor which senses the intensity of a magnetic field and which is inexpensive, small size, lighter weight, and yet suitable for mass production.

Prior Art

Today, many of conventional industrial equipment and consumer equipment includes rotating devices or rotating mechanisms such as motors and gears. Accurately controlling apparatuses for industrial and consumer use allows to address the problems such as environment preservation and energy saving. Recent advancement in science and technology has made it possible to accurately control devices for industrial use such as aircraft and ships and consumer equipment such as automotive vehicles.

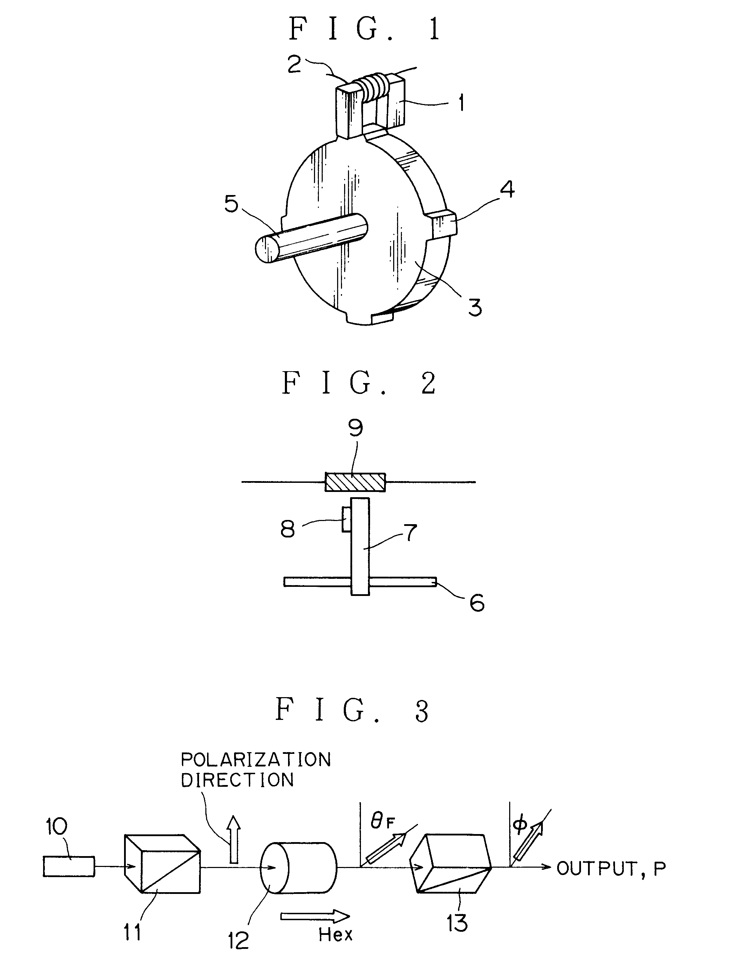

For more accurate and finer control of rotating apparatuses, the rotational speeds thereof must be measured both continuously and accurately. This measurement requires accurate measuring instruments which are simple, lighter weight, and readily available both at low costs and in large quantity. The measurement of rotational speeds includes a variety of methods. For example, a rotational speed meter (Fig. 1) based on electromagnetic induction, has been developed and used for measuring the rotational speeds of engines for aircraft and automotive vehicles (Sensor Gijutsu, Page 68, December, 1986.)

In Fig. 1, the probe of a rotational speed meter based on electromagnetic induction, is constructed of a permanent magnet 1, coil 2, and rotary disc 3 having magnetic properties. The rotary disc 3 is provided with projections 4 and is fixedly mounted on a shaft 5. When the rotary disc 3 rotates about the shaft 5, the projections 4 pass through the gap in the permanent magnet 1, resulting in changes in magnetic flux density in the permanent magnet 1 which in turn results in a current flowing through the coil 2 due to electromagnetic induction. The change in magnetic flux density in the permanent magnet 1 occurs since the magnetic flux flows through the projection 4.

Thus, the rotational speed of the disc 3 or shaft 5 can be known by counting the number of times the current flowing through the coil 2 changes in magnitude per unit time.

This type of rotational speed meter is susceptible to electromagnetic noise that comes in through the cables connecting the probe and the main body. Therefore, the lengths of the cables are limited, being inconvenient for remote measurement. Furthermore, since electrical circuits are involved, this type of rotational speed meter must be properly designed so that it can be used in environment where flammable materials such as organic solvents are used.

Recently, there has been growing interest in a rotational speed meter using optical signals, which is immune to electromagnetic interference and noise. This method for measuring rotational speed involves a magnetooptic sensor that makes use of Faraday effect of a magneto-optical material (Refer to Fig. 2, Applied Optics vol.28, p1991(1989)).

Fig. 2 shows a rotational speed meter using optical signals. The speed meter is constructed of a rotating body 7 such as gear, shaft 6 of the rotating body 7, permanent magnet 8 mounted on the rotating body 7, and magnetooptic sensor 9. When the rotating body 7 rotates about the shaft 6, the permanent magnet 8 attached to the rotating body 7 approaches the magnetooptic sensor 9 and then rotates away from the sensor 9. As is described later, it is known that the polarization plane of a light passing through a magneto-optical material rotates when the permanent magnet 8 approaches the magnetooptic sensor 9. Thus, the rotational speed of the shaft 6 can be determined by converting the rotation of the polarization plane into the change in intensity of a light which indicates the presence and absence of magnetic field. Counting the changes in intensity of the light reveals the rotational speed. Fig. 3 shows the principle of measuring rotational speeds using optical signals (National Technical Report, Vol.29, No.5, p70(1983)). In the figure, a light emitted from a light source 10 such as a semiconductor laser, enters a polarizer 11 in the form of, for example, calcite. The light exiting the polarizer 11 is a linearly polarized light where the polarization plane is aligned in one direction, and enters a Faraday rotator 12 which is usually made of magneto-optical material such as lead glass.

The polarization plane of the light from the Faraday rotator 12 has been rotated by $\theta_F$ in accordance with the magnetic field Hex in which the rotator 12 is placed. The light from the Faraday rotator 12 then enters an analyzer 13 made of, for example, calcite.

The intensity P of the light exiting the analyzer 13 is given by

$$P = k \cos^2(\phi - \theta_F) \qquad (1)$$

where $\phi$ is an angle of the polarizer 11 relative to the analyzer 13, $\theta_F$ is an angle through which the polarization plane rotates, and k is a proportional constant. Assuming that $\phi$ is equal to 45 degrees, Equation (1) can be rewritten as follows:

$$P = k (1 + \sin 2\theta_F)/2 \qquad (2)$$

Further, if $\theta_F$ is sufficiently small, Equation (2) can be approximated as follows:

$$P = k (1 + 2\theta_F)/2 \qquad (3)$$

Equation (3) indicates that the intensity of a light becomes proportional to $\theta_F$ if $\phi$ is selected to be 45 degrees. In other words, the rotational angle $\theta_F$ of the polarization due to an applied magnetic field Hex can be detected or measured in terms of the intensity of the light by the use of the analyzer 2.

Various proposals have been made to the systems and configurations of a magnetic field sensor. They can be grouped into two types, a transmission type and a reflection type. Fig. 3 shows the construction of a transmission type magnetooptic sensor. With this type of sensor, because of the nature of the constructional elements, the elements must be aligned in a straight line such that the light goes through straightly. Thus, if some obstructions are located in the course of the light, the magnetooptic sensor cannot be placed in position.

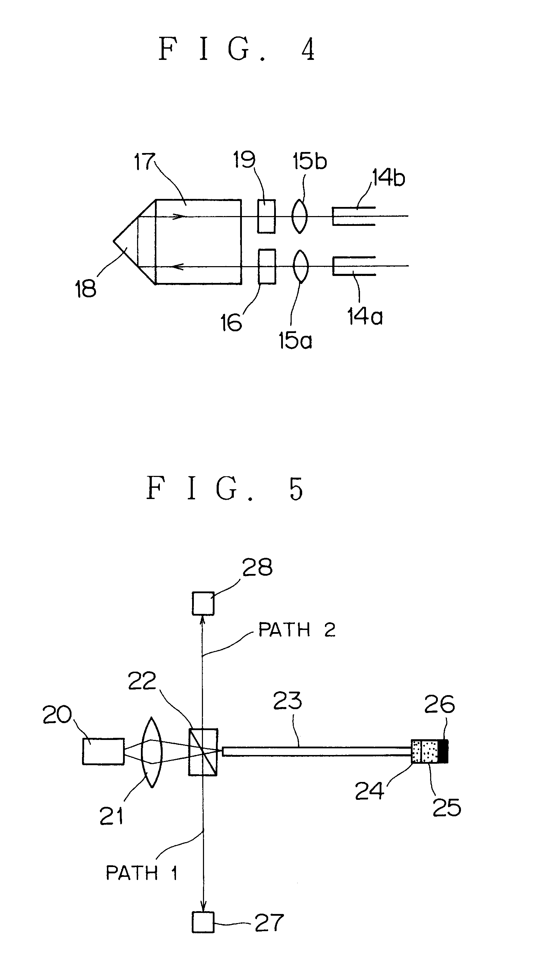

Meanwhile, Japanese Patent Preliminary Publication No.56-55811 discloses a reflection type magnetooptic sensor which overcomes the deficiencies of the transmission type. Fig. 4 shows the general construction of this reflection type magnetooptic sensor. In Fig. 4, a signal light passes through an optical fiber 14a and then through a lens 15a to a polarizer 16 made of, for example, a rutile single crystal. The light from the polarizer 16 enters a Faraday rotator 17 to a rectangular prism 18 which reflects the light back to the Faraday rotator 17. The light from the Faraday rotator 17 is incident upon the analyzer 19 and is then coupled via a lens 15b to an optical fiber 14b.

The construction of the reflection type in Fig. 4 differs from the transmission type in that the rectangular prism 18 is provided to reflect the signal light. With a reflection type magnetooptic sensor, the input and output optical fibers are on the same side with respect to the Faraday rotator 17 and in parallel with each other as shown in Fig. 4. The reflection type magnetooptic sensor is advantageous in a system where the transmission type magnetooptic sensor cannot be installed. However, the reflection type sensor has a disadvantage that the lens 15a must be in series with the polarizer 16, the lens 15b must be in series with the analyzer 19, and these two series connections must be in parallel with each other. This requirement of aligning the elements places limitations on automatic assembly operation of the entire system, and is not cost effective.

A configuration where the polarizer 16 and the analyzer 19 are replaced by a single polarizer has been proposed so as to overcome the disadvantages of the reflection type magnetooptic sensor shown in Fig. 4 (Fig. 5, Japanese Patent Publication No.3-22595). In Fig. 5, the light emitted from a light source 20 such as a semiconductor laser, passes through a lens 21 and a half mirror 22 by which the light is condensed, and then enters an optical fiber 23. The half mirror 22 reflects the light incident thereupon to a light path 1. A photodetector 27 placed in the light path 1 serves to measure variations in the intensity of the light emitted from the light source 20. The signal light directed to the optical fiber 23 passes through a polarizer 24 made of, for example, a rutile single crystal, and a Faraday rotator 25 made of a magnetic garnet to a reflective film 26. The reflective film 26 is usually made of the multilayer of a dielectric material.

The light reached the reflective film 26 is then reflected back to the Faraday rotator 25 and the polarizer element 24. Then, the light exiting the polarizer 24 enters the optical fiber 23. The light incident upon the optical fiber 23 enters the half mirror 22. The light passing through the half mirror 22 is reflected by the half mirror 22 into a light path 2, and then enters the photodetector 28 which measures the intensity of the light.

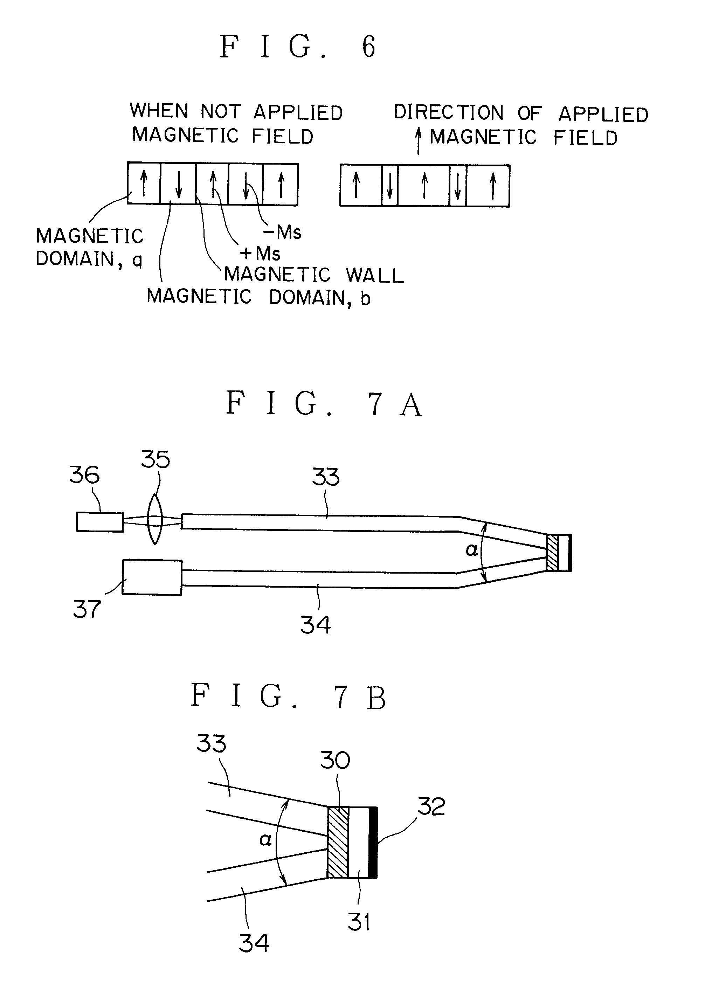

The configuration in Fig. 5 corresponds to a case where the polarizer 1 in Fig. 3 makes an angle of zero degrees with the analyzer 2, i.e., $\phi = 0$. Thus, the intensity of the light through the polarizer 24 (corresponds to the analyzer 2 in Fig. 3), i.e., the light arriving at the photodetector 28 is given by Equation (1) as follows:

$$P = k \cos^2 \theta_F \qquad (4)$$

4

It is disadvantageous that the variation of intensity P of the light signal given by Equation (4) is very small compared to the intensity P given by Equation (3) if $\theta_F$ is small. However, the configuration in Fig. 5 is considerably simple compared to that in Fig. 2, and is easy to assemble.

The reflection type magnetooptic sensor shown in Fig. 4 (Japanese Patent Publication No. 3-22595) employs a yttrium iron garnet ($Y_3Fe_5O_{12}$) usually referred to as YIG, as a Faraday rotator produced using flux melt technique. Conventional optical sensors use a light source such as a semiconductor laser (LD) or a light emitting diode (LED) having median wavelengths in the range of 0.78-0.85 $\mu$m. Semiconductor lasers and light emitting diodes are used as a light source for a photosensor because they are available at very low costs in the above wavelength range as well as a photodetector has a good sensitivity in this range.

Conventional light sources for a photosensor have wavelengths in the 0.8 $\mu$m band. YIG shows a good transmissivity in the near infrared light region higher than 1.1 $\mu$m while at the same time it absorbs lights in the 0.8 $\mu$m band. High absorption of light implies that it is difficult to detect light and it is seriously detrimental as a magnetooptic sensor.

Recently, bismuth-substituted iron garnets have been highlighted as a magneto-optical material alternative to YIG. Bismuth-substituted iron garnets can be rather easily manufactured by LPE (Liquid Phase Epitaxial) method, and is suitable for mass production. Bismuth-substituted iron garnets are expressed by a chemical formula $(RBi)_3(FeA)_5O_{12}$. The letter R represents yttrium Y or rare earth elements and A represents aluminum Al and gallium Ga. The Faraday rotation coefficient of the bismuth-substituted iron garnet, i.e., the rotation angle of the polarization plane or unit film thickness at saturated magnetization is as large as several times the Faraday rotation of YIG (about ten times at 0.8 $\mu$m.) This indicates that the film thickness can be thinner with increasing Faraday rotation coefficient for the same magneto-optical effect, achieving less light absorption loss and smaller size. The film thickness and light absorption loss of an element can be smaller in bismuth-substituted iron garnets than in YIG, showing possibility in implementation of a magnetooptic sensor with a light source having wavelengths in the 0.8 $\mu$m band.

The magnetic saturation (500-1200 Oe) of bismuth-substituted iron garnets is on the order of a half that of YIG (about 1800 Oe.) This indicates that the bismuth-substituted iron garnets can be used to measure weak magnetic fields. The ability of measuring weak magnetic fields represents that the distance between the permanent magnet and the magnetooptic sensor, e.g., the distance between the permanent magnet 8 and the magnetooptic sensor 9 in Fig. 2, can be longer. This provides more flexibility and higher degree of freedom in allocating the magnetooptic sensor and suggests more fields of application for a magnetooptic sensor.

Implementing a magnetooptic measuring apparatus using bismuth-substituted iron garnets instead of YIG, also provides great advantages in terms of manufacturing cost. The inventors of the present invention built an engineering model of a reflection type magnetooptic sensor using a Faraday rotator made of a bismuth-substituted iron garnet single crystal. Then, using the reflection type magnetooptic sensor, the inventors made a variety of experiments for various magnetic field intensities. However, the sensor failed to detect any light signal.

Therefore, the inventors made various experiments in order to find out the reason why the reflection type magnetooptic sensor according to Fig. 5 failed to detect light signals. After having made many experiments, the inventors finally realized that the sensor failed to detect light due to the structure of magnetic domains in the Faraday rotator. The inventors realized that a reflection type magnetooptic sensor of the construction in Fig. 5 cannot detect light signals if the Faraday rotator is made of a multidomain element such as bismuth-substituted iron garnets, which have a number of magnetic domains.

Although further experiments are needed to obtain more detailed and exact reasons, the following discussion based on the experimental results will help us understand the phenomenon. Let's consider the principle of a rotational speed meter or a magnetooptic measuring apparatus using a reflection type magnetooptic sensor shown in Fig. 5. Magneto-optical materials are generally grouped into two groups; one is a single magnetic domain material and the other is a multidomain material such as bismuth-substituted iron garnets which have a number of magnetic domains. The single magnetic domain materials differ from the multidomain materials in that they are magnetized in a completely different manner (PHILIPS TECHNICAL REVIEW, Vol. 35, p1 (1975).)

An magneto-optical material placed in a magnetic field is magnetized throughout the material in proportion to the intensity of the applied magnetic field. As a result, the rotational angle $\theta_F$ of the polarization plane varies in proportion to the intensity of the applied magnetic field Hex. The angle $\theta_F$ is given by

$$\theta_F = \text{Hex L V} \quad (5)$$

where L is the length of the element, V is a proportional constant referred to as Verdet constant. Equation (5) indicates that the angle $\theta_F$ is zero degrees when Hex is zero. Thus, in Fig. 5, the intensity P of the light reflected back corresponds to an angle $\theta_F$ of zero degrees. Thus, Equation (4) can be rewritten as follows:

$$P = k \qquad (6)$$

When the intensity of the applied magnetic field, in which the magneto-optical material lies, is not zero but a certain value Hex, the intensity P of a light reflected back is given as follows:

$$P = k \cos^2(\text{Hex L V}) \qquad (7)$$

Thus, a magneto-optical measuring apparatus or rotational speed meter, which uses a Faraday rotator made of a magneto-optical material having a single magnetic domain such as lead glass, measures rotational speeds by measuring the difference in the intensities of single lights expressed by Equations (6) and (7).

Multidomain materials such as a bismuth-substituted iron garnet single crystal thin film have a crystal orientation [111] which is grown on a (111) non-magnetic garnet $(CaGd)_3(GaMgZr)_5O_{12}$ by LPE method. The orientation in which the material is more easily magnetized, as shown in Fig. 6, is perpendicular to the film surface when the material is not placed in a magnetic field. The direction in which the material is easily magnetized includes two directions; one is downward from the substrate toward the film surface and the other is upward from the substrate toward the film surface. Each of areas having different magnetization orientations is referred to magnetic domain. The widths of magnetic domains differ depending on the compositions of bismuth-substituted iron garnet single crystal thin films and/or the thickness of the thin film, ranging from several $\mu$m to several tens of $\mu$m. The domains are bounded by very narrow magnetic walls. The Faraday rotation angle and intensity of magnetization of respective magnetic domains are such that, for example, domain a has $+\theta_F$ and $+$Ms while domain b has $-\theta_F$ and -Ms, and will show little or no change even when they are placed in a magnetic field of several kilo oersteds.

When domain a is placed in a magnetic field of the same direction as magnetization $+$Ms, the magnetic wall shifts toward domain b, so that domain b gradually decreases in volume. When the intensity of the magnetic field reaches a certain value, domain b extinguishes and all the domains are magnetized in the same direction as the applied magnetic field. Then, the domains are said to be magnetically saturated. Faraday rotation angle $\theta_F$ can be measured with the magnetization saturated. When a linearly polarized light enters a Faraday rotator having multidomain, the rotation direction of polarization plane of the light transmitted through the rotator is different from domain to domain. If the polarization plane of a light transmitted through domain a rotates rightwards through an angle of 30 degrees, the polarization plane of a light transmitted through domain b rotates leftwards through an angle of 30 degrees. The light reflected back by the reflecting surface again passes through the same domain. In other words, the light through domain a is reflected by a reflecting surface and again passes through the domain a, causing the polarization plane of the light transmitted through the domain a to further rotate through an angle of 30 degrees. Therefore, the light passing through domain a rotates leftwards through an angle of 60 degrees from the original polarization plane. Similarly, the light passing through domain b rotates through an angle 60 degrees.

For both domains a and b, the intensity of a light reflected back is given by Equation (4).

$$P = k \cos^2(60)$$

Meanwhile, multidomain becomes single domain when it is magnetically saturated. Thus, the polarization plane of reflected light rotates through 60 degrees either leftwards or rightwards. The intensity of the reflected light is given by Equation (4) as follows:

$$P = k \cos^2(60)$$

This indicates that multidomain will not result in the change in intensity of light regardless of whether the rotator is placed in a magnetic field. This indicates that a Faraday rotator with multidomain will not result in the change in intensity of light, regardless of whether the rotator is placed in a magnetic field, and therefore, a reflection type magnetooptic sensor in Fig. 5 using a Faraday rotator with multidomain does not function as a magnetooptic measuring apparatus or rotational speed meter. This fact theoretically supports the experimental results obtained by the inventors of the present invention.

However, Japanese Patent Publication No. 3-22595 discloses a Faraday rotator of YIG which has the same multidomain as bismuth-substituted iron garnets and does not agree to the experimental results and investigation. The inventors of the present invention still wonder as to why a bismuth-substituted iron garnet with multidomain did not properly function as a Faraday rotator in a reflection type magnetooptic sensor built according to the configuration in Fig. 5 similar to the YIG in Japanese Patent Publication No. 3-22595, though a YIG has the same multidomain functioned properly as a Faraday rotator in Japanese Patent Publication No. 3-22595. The failure to properly function is yet to be studied.

As is described in detail, the reflection type magnetooptic sensor of the construction in Fig. 5 disclosed in Japanese Patent Publication No. 3-22595 functions properly if the Faraday rotator is made of a magneto-optical material such as lead glass having single domain, but does not function properly if the Faraday rotator is made of a magneto-optical material such as a (111) bismuth-substituted iron garnet single crystal having multidomain.

## SUMMARY OF THE INVENTION

The present invention relates to a reflection type magnetooptic sensor head wherein the light path for a light-inputting/outputting device is split into two paths; an inputting path and an outputting path arranged such that one of the paths makes an angle greater than five degrees with the other.

In more detail, the present invention relates to a magnetooptic sensor head using a bismuth-substituted iron garnet given by chemical structure $(RBi)_3(FeA)_5O_{12}$ (where R represents yttrium Y or rare-earth elements, and A represents aluminum and gallium etc.)

The head includes a reflection film, (111) bismuth-substituted iron garnet single crystal film, polarizer, and light-inputting/outputting devices, which are aligned in this order from the tip end of the magnetooptic sensor head.

The present invention also relates to a magneto-optical measuring apparatus in which the aforementioned magnetooptic sensor is incorporated as a magnetic field detecting sensor.

## BRIEF DESCRIPTION OF THE DRAWINGS

Features and other objects of the invention will become more apparent from the description of the various examples with reference to the accompanying drawings in which;

Fig. 1 schematically shows one basic construction of a rotational speed meter for a crank shaft using electromagnetism;

Fig. 2 shows a general construction of a rotational speed meter using a magnetooptic sensor;

Fig. 3 shows the principle and basic construction of a magnetooptic sensor using Faraday effect;

Fig. 4 shows the basic construction of a reflection type magnetooptic sensor head disclosed in Japanese Patent preliminary Publication No. 56-55811;

Fig. 5 shows the basic construction of a reflection type magnetooptic sensor disclosed in Japanese Patent Preliminary Publication No. 3-22595;

Fig. 6 shows the principle and magnetic domain structure of a bismuth-substituted iron garnet formed on a non-magnetic garnet substrate;

Fig. 7 shows the general construction of a magneto-optical measuring apparatus based on a reflection type magnetooptic sensor for Example 1 of the invention and a reflection type magnetooptic sensor used as a magnetic field sensor;

Fig. 8 shows the basic construction of a magnetooptic sensor head used in Example 1;

Fig. 9 shows a glass plate 40 and optical paths B before the optical paths B are ground flush with the glass pate end;

Fig. 10 shows the basic construction of a magnetooptic sensor head used in Comparison 1; and

Fig. 11 shows the basic construction of a magnetooptic measuring apparatus used in Comparison 1.

## DESCRIPTION OF THE PREFERRED EXAMPLES

Bismuth-substituted iron garnets have characteristics suitable for a magneto-optical material, and can be relatively easily manufactured by LPE on an industrial basis. Thus, the inventors of the present invention put much effort in developing a highly sensitive reflection type magnetooptic sensor using a Faraday rotator made of a bismuth-substituted iron garnet. The inventors concluded that a reflection type magnetooptic sensor could be constructed of a reflection film, (111) bismuth-substituted iron garnet single crystal film, polarizer, and light-inputting/outputting devices. The aforementioned structural elements are disposed in such a way that the light path for the light-inputting/outputting devices is split into two paths; an inputting path and an outputting path arranged such that one of the two paths makes an angle α greater than five degrees with the other.

Fig. 7 shows a sensor according to the present invention. In Fig. 7, a polarizer 30 is, for example, POLACORE (Trade name) sold by CORNING and a Faraday rotator 31 is made of a bismuth-substituted iron garnet which is magnetized most easily in a direction normal to the film surface. The Faraday rotator 31 is exposed to a magnetic field to be measured. A reflection film 32 is, for example, in the form of a dielectric. An optical waveguide 33 for incoming lights is formed on glass or polymer, or is in the form of an optical fiber. An optical waveguide 34 for outgoing lights is formed on glass or polymer, or is in the form of an optical fiber. The light emitted from a light source 36 such as semiconductor laser, is directed through a lens 35 into the incoming light path 33. The light entered the path 33 then passes through the polarizer 30 and the Faraday rotator 31 to the reflection film 32. The light is then reflected by the polarizer back through the Faraday rotator 31, the polarizer 30, and the light path 34 to a photodetector 37 which detects the light as a light signal. The light paths 33 and 34 make an angle φ greater than five degrees with respect to each other.

It should be noted that the reflection film 32, (111) bismuth-substituted iron garnet single crystal film 31, polarizer 30, and light-inputting/outputting device 33 and 34, are aligned in this order from the tip end of the magnetooptic sensor head.

In the present invention, a magnetooptic sensor head uses a bismuth-substituted iron garnet given by chemical structure $(RBi)_3(FeA)_5O_{12}$ where R represents yttrium Y or rare-earth elements, and A represents aluminum and gallium etc.

In order to clearly distinguish state 1 where a Faraday rotator is in the absence of an external magnetic field, from state 2 where the magnetization of a Faraday rotator is almost saturated, it is said that the intensity of light should differ at least more than 2 dB, taking into account the stability of a light source and the accuracy and stability of a photodetector as well as effects of the light reflected from the end surfaces of structural elements.

The inventors of the present invention measured the power of lights in state 1 and state 2 for different values of angle φ made by the two light paths 33 and 34 in Fig. 7. The inventors noted that the difference in light power between states 1 and 2 detected by the photodetector is large with increasing value of angle φ. The inventors carried out further experiments and confirmed that the difference is less than 2 dB for angle φ less than five degrees but more than 2 dB for angle φ greater than five degrees. Despite the favorable results, the inventors have not fully investigated as to why the magnetic field strength can be measured by arranging the paths 33 and 34 at an angle of more than five degrees with respect to each other. It could be explained that when a light is transmitted through a bismuth-substituted iron garnet single crystal film, the light entering in a direction normal to the film surface passes a different path from the lights entering in a direction at an angle i.e., the light passes different magnetic domain. That is, in Fig. 6, It is assumed that a light enters a bismuth-substituted iron garnet which is not applied with a magnetic field, and is then reflected back to the light source, and then passes through magnetic domains a alternately with magnetic domains b. It is also assumed that the Faraday rotation is 30 degrees when the magnetization is saturated. Then, the rotation angle $\theta_F'$ of the polarization plane of the reflected light is given as follows:

$$\theta_F' = +30(-30)$$
$$= 0$$

Meanwhile, when the bismuth substituted iron garnet is applied with a magnetic field and is saturated, the rotation angle $\theta_F$ is given as follows:

$$\theta_F = \pm\ 30 * 2$$
$$= \pm\ 60\ degrees$$

The difference P in intensity of light between when the bismuth-substituted iron garnet is saturated with an applied magnetic field and when not applied with a magnetic field, is given as follows:

$$\Delta P = 10 * \log\{\cos^2(0)/\cos^2(60)\}$$

$$= 6.0 \text{ dB}$$

This result supports the assumption that when the signal light passes through a bismuth-substituted iron garnet, the probability of passing through different magnetic domains increases with increasing angle which the incoming-light path makes with the outgoing-light path, thus increasing $\Delta P$ or higher sensitivity.

The larger angle the incoming-light path makes with the outgoing-light paths, larger space the two paths take up, resulting in larger size of the magnetic sensor. Larger size of a magnetic sensor makes a reflection type magnetooptic sensor less attractive. Further, even if the two light paths make an angle greater than 120 degrees with respect to each other, the difference $\Delta P$ will not increase significantly. Thus, in order to make full use of the advantages of a reflection type magnetooptic sensor, there is a limitation in the angle that the two light paths make with respect to each other. When manufacturing an apparatus according to the present invention, the angle which the two light paths make with respect to each other is optimized according to a desired sensitivity and the size of a magnetooptic sensor head. The angle is in the range from more than five degrees to less than 120 degrees. If high sensitivity and small sensor-head size are prime importance, the angle should be in the range from ten to 90 degrees, preferably from 30 to 70 degrees.

The polarizer in the present invention need not be a special type and may be selected from commercially available polarizers. A dichroic polarizer is particularly preferred for small thickness and high extinction ratio.

When manufacturing a magnetic sensor according to the present invention, there is not particular restriction on the compound of a bismuth-substituted iron garnet. It is preferable to select from magnetic garnet crystals given by a general chemical structure:

$$R_{3-x}Bi_xFe_{5-z}A_zO_{12}$$

where R is at least one of Y, La, Ce, Pr, Nd, Sm, Eu, Gd, Tb, Dy, Ho, Er, Tm, Yb, and Lu, and A is at least one of Ga, Sc, Al, and In, and $0.3 \leq X \leq 2$ and $0 \leq Z \leq 1.0$.

Although a bismuth-substituted iron garnet single crystal according to the invention can be manufactured by any well known process, LPE process (Thin Solid Film, Vol. 114, P33(1984)) is preferred for its simple operation and advantage of quantity production. In the LPE process, any known substrate can be used and is usually selected from non-magnetic garnet $[(GdCa)_3(GaMgZr)_5O_{12}]$ having a lattice constant in the range from 12.490 Å to 12.515 Å referred to as SGGG substrate available on the market.

The non-magnetic substrate on which a bismuth-substituted iron garnet thin film is formed, need not be removed at a later time. The non-magnetic substrate may be preferably left as a support to enhance mechanical strength if the thin film of a bismuth-substituted iron garnet single crystal is as thin as several tens of microns. If a bismuth-substituted iron garnet is as thick as several hundreds of microns, the material is strong enough so that the non-magnetic substrate may be removed by grinding.

There is no particular requirement for the reflection film and it is preferred to use a mirror made of a metal film deposited on glass on the market, a bismuth-substituted iron garnet film, metallic mirror made by depositing gold or aluminum directly on a non-magnetic substrate, or dielectric multilayer mirror made of multilayer of metal oxides such as $SiO_2$ and $TiO_2$. The reflection film may be provided either on the side of the bismuth-substituted iron garnet single crystal film or on the side of the substrate.

The incoming-light path and outgoing-light path do not have to be of a special type. The incoming-light path may be an optical fiber and the outgoing-light path may be optical waveguides patterned in glass or high polymer film, or air, and optical fibers are particularly preferred for mass production and small size. Any type of optical fiber may be used for the light paths but, those having core diameters less than 50 $\mu$m causes the width of magnetic domain of a bismuth-substituted iron garnet to affect the characteristics of a sensor, resulting in unstable sensitivity and lower optical coupling efficiency. Optical fibers having diameters greater than 400 $\mu$m makes the head larger. Thus, diameters in the range from 50 to 400 $\mu$m are preferred and more particularly from 100 to 250 $\mu$m.

There is no specific requirement for the assembly configuration of the reflecting film, bismuth-substituted iron garnet single crystal, and polarizer. It is preferred that these elements are stacked and bonded into a unitary construction which is then cut into preferred dimensions. This way of manufacturing is suitable for mass production and simple handling of the head.

The wavelength of a light source of a magnetooptic measuring apparatus is selected taking into account the sensitivity of a Faraday rotator, light transmittance, the performance and cost of a light source, and the sensitivity of a detector. In the present invention, the wavelength of a light source is preferably selected from a near infrared light in the range from 780 to 850 nm for the following reasons.

(1) A bismuth-substituted iron garnet includes regions called "window" where optical absorption coefficient is relatively small.

(2) The Faraday rotation of a bismuth-substituted iron garnet is large.

(3) A bismuth-substituted iron garnet has film thickness from 50 to 100 $\mu$m and is easy to manufacture.

(4) Short wavelength semiconductor lasers and light emitting diodes of high output are commercially available at low costs.

(5) The photodetector is highly sensitive and is available at low costs.

Preferable second alternative wavelengths are in the 1300 nm band and 1550 nm band used in optical fiber communications, or 1060 nm for which YAG lasers can be used.

At wavelengths beyond these ranges, optical absorption may be higher, or smaller Faraday rotations of a bismuth-substituted iron garnet necessitates the thicker film of a Faraday rotator which in turn makes it difficult to manufacture a Faraday rotator by LPE method.

The present invention will now be described in detail by way of specific examples as follows:

Example 1

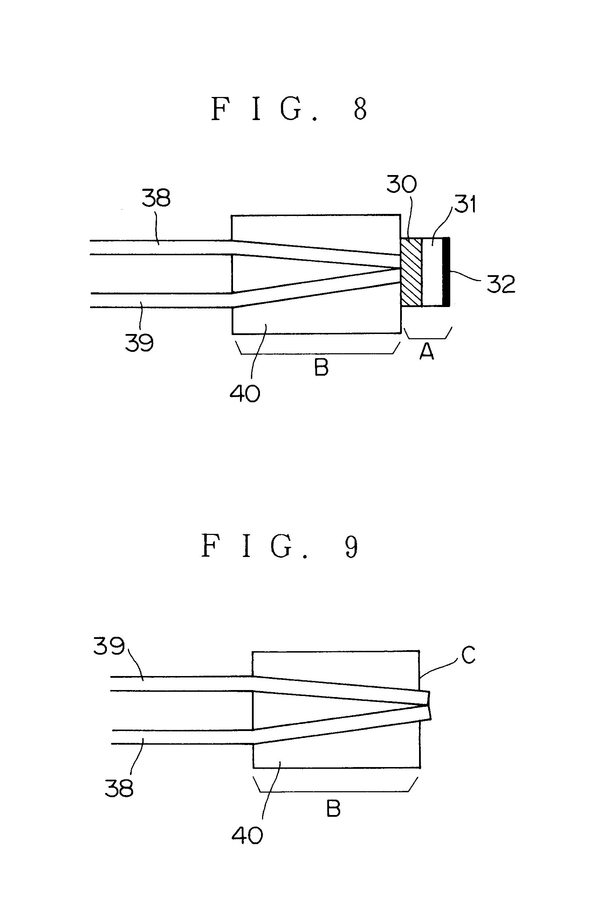

Fig. 8 shows an example of a magnetooptic sensor according to the present invention. In the figure, plate-like glass 40 carries optical fibers 38 and 39 fixed thereon. A Faraday rotator, reflecting film, and polarizer are shown at 31, 32, and 30, respectively.

The Faraday rotator 31 was manufactured in the following manner. A 500 milliliter platinum crucible was placed in an LPE furnace, which platinum crucible contains therein lead oxide (PbO, 4N) of 843 grams, bismuth oxide ($Bi_2O_3$, 4N) of 978 grams, ferric oxide ($Fe_2O_3$, 4N) of 128 grams, boron oxide ($B_2O_3$, 5N) of 38 grams, terbium oxide ($Tb_4O_7$, 3N) of 4.0 grams, and holmium oxide ($Ho_3O_3$, 3N) of 9.0 grams. The content of the crucible was heated to a temperature of 1000 degrees to melt. The melted content was sufficiently beaten for uniform mixture and was then cooled down to a melt temperature of 770 degrees so as to produce a melt for growing a bismuth substituted magnetic garnet single crystal.

Then, using a know procedure, a two-inch (111) substrate of a garnet single crystal $(GdCa)_3(GaMgZr)_5O_{12}$ having a thickness of 480 $\mu$m and a lattice constant of 12.497±0.002 angstroms, was placed on the surface of the thus produced melt for 2.0 hours for epitaxial growth while maintaining the melt temperature at 770 degrees. Obtained was a bismuth-substituted iron garnet single crystal having a compound of $Ho_{1.1}Tb_{0.6}Bi_{1.3}Fe_5O_{12}$ (HoTbBiIG single crystal) and having a film thickness of 46 $\mu$m. This crystal showed a Faraday rotation $\theta_F$ of 42.5 degrees at a wavelength of 0.78 $\mu$m with saturated magnetization.

The thus manufactured HoTbBiIG single crystal was sliced into a size of 10 mm x 10 mm. Using a known procedure, the single crystal was then polished on the substrate side to a thickness of 200 $\mu$m. Then, a reflection film of gold was formed on the side of HoTbBiIG single crystal, and an antireflection film of a thickness of 0.78 $\mu$m on the substrate side.

Then, a dichroic polarizer (The trade name is POLACORE) was bonded to the substrate side of the (HoTbBiIG) single crystal with epoxy adhesive. The thus bonded structure is cut with a dicing machine into square shapes of 1.5 mm x 1.5 mm as shown by A in Fig. 8. Meanwhile, a 3 mm x 3 mm rectangular glass 40 of one millimeter thickness was formed with two grooves of a 300 $\mu$m depth and a 300 $\mu$m width at five degrees with respect to each other using a dicing machine (Fig. 9.) In the grooves of the glass 40 were buried plastic clad fibers 38 and 39 of a 230 $\mu$m outer diameter and a core diameter 200 $\mu$m. The fibers 38 and 39 were bonded to the glass 40 with epoxy adhesive (Fig. 9.) Then, fiber ends protruding from end C were removed by grinding method until the fibers were flush with the end C, resulting in a portion B as shown. The portions A and B were bonded together with epoxy adhesive into a magnetooptic sensor head.

As shown in Fig. 7, the quartz fiber 38 that serves as the incoming-light path 33 was connected to the light source 36 via the lens 35, while the quartz fiber 39 that serves as the outgoing-light path was connected to the photodetector 37.

A light of a 0.78 $\mu$m wavelength was exposed so as to input a light having an intensity of -6 dBm into the optical fiber and the intensity of the light reflected back to the optical fiber 39 was measured. The intensity of the reflected light was -25.6 dBm without a magnetic field applied to the Faraday rotator and -28.4 dBm with a magnetic field of 1500 Oe applied for magnetic saturation. Thus, the difference in intensity between the two lights was 2.8 dB.

Example 2

A magnetooptic sensor head having the same portion A as Example 1 was manufactured in a similar manner to Example 1 except that the two grooves in the glass 40 were at an angle of 20 degrees. The intensity of the reflected light was -18.2 dBm without a magnetic field applied to the Faraday rotator and -30.3 dBm with a magnetic field of 1500 Oe applied for magnetic saturation. Thus, the difference in intensity between the two lights was 12.1 dB.

Example 3

A magnetooptic sensor head was manufactured in the manner as in Example 1 except that the two grooves made an angle of 60 degrees with respect to each other, and measurement was made in a similar manner to Example 1.

The intensity of the reflected light was -17.5 dBm without a magnetic field applied to the Faraday rotator, and -30.6 dBm with a magnetic field of 1500 Oe applied for magnetic saturation. Thus, the difference in intensity between the two lights was 13.1 dB.

Example 4

A magnetooptic sensor head was manufactured in the manner as in Example 1 except that the two grooves made an angle of 80 degrees with respect to each other, and measurement was made in a similar manner to Example 1.

The intensity of the reflected light was -20.2 dBm without a magnetic field applied to the Faraday rotator, and -33.0 dBm with a magnetic field of 1500 Oe applied for magnetic saturation. Thus, the difference in intensity between the two lights was 12.8 dB.

Comparison 1

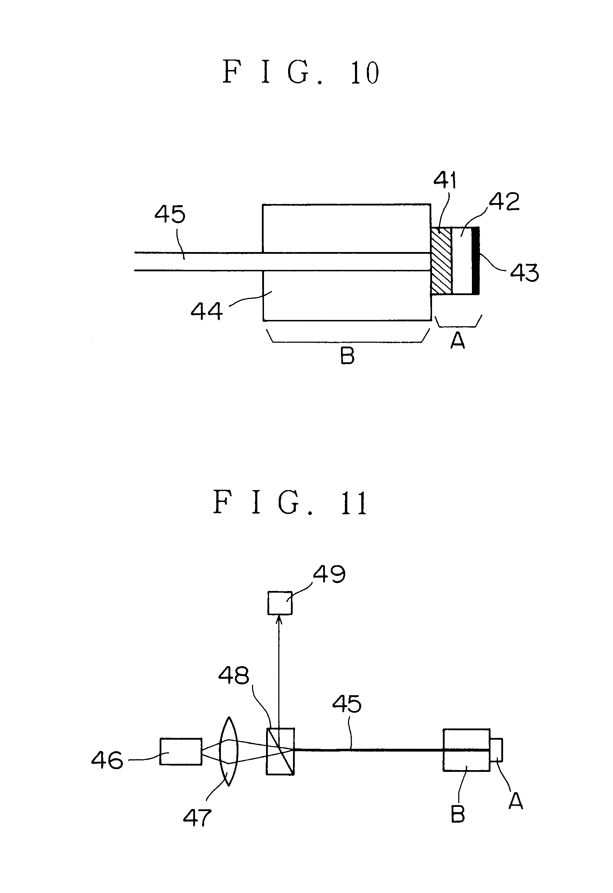

A magnetooptic sensor head having the same portion A as Example 1 was manufactured in the manner as in Example 1 except that the glass 40 was formed with only one groove having a 300 $\mu$m width as shown in Fig. 10. The thus manufactured magnetooptic sensor head was connected via an optical fiber 45 to a half mirror 48 as shown in Fig. 11.

A light of a 0.78 $\mu$m wavelength was exposed so as to input a light having an intensity of -4 dBm into the optical fiber 45 and the intensity of the light reflected back to the optical fiber 39 was measured. The intensity of the reflected light was -28.0 dBm without a magnetic field applied to the Faraday rotator and -28.2 dBm with a magnetic field of 1500 Oe applied for magnetic saturation. Thus, the difference in intensity between the two lights was 0.2 dB.

Comparison 2

A magnetooptic sensor head having the same portion A as Example 1 was manufactured in the manner as in Example 1 except that the two grooves were at an angle of four degrees. The intensity of the reflected light was -25.3 dBm without a magnetic field applied to the Faraday rotator and -26.7 dBm with a magnetic field of 1500 Oe applied for magnetic saturation. Thus, the difference in intensity between the two lights was 1.4 dB.

**Claims**

1. A reflection type magnetooptic sensor head comprising:
   a reflection film;
   a (111) bismuth-substituted iron garnet single crystal film;
   a polarizer; and
   a light-inputting/outputting device having an incoming-light path and an outgoing light path, said incoming light path making an angle substantially greater than five degrees with said outgoing-light path.

2. The reflection type magnetooptic sensor head of Claim 1, wherein said reflection film, said (111) bismuth-substituted iron garnet single crystal film, said polarizer, and said light-inputting/outputting device are aligned in this order beginning from a tip end of the magnetooptic sensor head.

3. A magnetooptic measuring apparatus using a reflection type magnetooptic sensor head as a magnetic field detecting sensor, said detecting sensor comprising:
    an incoming-light path: and
    an outgoing-light path; wherein said incoming light path makes an angle substantially greater than five degrees with said outgoing light path.

# F I G . 1

# F I G . 2

# F I G . 3

POLARIZATION
DIRECTION

$\theta_F$

$\phi$

OUTPUT, P

Hex

# F I G . 4

# F I G . 5

# F I G . 6

WHEN NOT APPLIED
MAGNETIC FIELD

DIRECTION OF APPLIED
↑ MAGNETIC FIELD

MAGNETIC
DOMAIN, q

−Ms
+Ms
MAGNETIC WALL
MAGNETIC DOMAIN, b

# F I G . 7 A

# F I G . 7 B

F I G . 8

38

30

31

32

39

40

B

A

F I G . 9

39

C

38

40

B

# F I G . 10

# F I G . 11